# EUROPEAN PATENT APPLICATION

(11) **EP 4 554 340 A1**
(43) Date of publication of application: **14.05.2025**
(21) Application number: 23209007.6
(22) Date of filing: 10.11.2023
(51) Int. Cl.: H05K 1/03, H05K 1/18, H05K 3/46

(54) **COMPONENT CARRIER WITH DISTINCT RESIN FLOWED PORTIONS, AND MANUFACTURING METHOD**

(71) Applicant: AT&S Austria Technologie & Systemtechnik Aktiengesellschaft, 8700 Leoben (AT)
(72) Inventor: Moitzi, Ewald, 8740 Zeltweg (AT); Lebernegg, Patrick, 8700 Leoben (AT); Csarnai, Viktor, 8700 Leoben (AT); Kristl, Thomas, 8793 Trofaiach (AT)
(74) Representative: Dilg, Haeusler, Schindelmann Patentanwaltsgesellschaft mbH

(57) **Abstract**

There is described a component carrier (100) having a stack (101) that comprises:
i) a core layer (110);
ii) a first electrically insulating layer structure (120) arranged on a first main surface of the core layer (110);
iii) a second electrically insulating layer structure (130) arranged on a second main surface of the core layer (110), wherein the second main surface is opposed to the first main surface;
iv) a cavity (140) in the core layer (110), wherein the core layer (110) defines a cavity lateral wall (145);
v) a component (150) with a component lateral wall (155), at least partially inserted in said cavity (140).

The first electrically insulating layer structure (120) and the second electrically insulating layer structure (130) extend at least partially into the cavity (140), so that in a region (160) between the cavity lateral wall (145) and the component lateral wall (155), a first distinct resin flowed portion (126) of the first electrically insulating layer structure (120) and a second distinct resin flowed portion (136) of the second electrically insulating layer structure (130) are provided.

## Description

### Field of the Invention

The invention relates to a component carrier with a stack that comprises a core layer and at least two electrically insulating layer structures. A component is embedded in a cavity in the stack, wherein distinct resin flow portions of the at least two electrically insulating layer structures extend into said cavity. Further, the invention relates to a method of manufacturing said component carrier.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular embedding a component (e.g. a semiconductor element) in a component carrier multi-layer stack in an efficient and stable manner may still be considered a challenge.

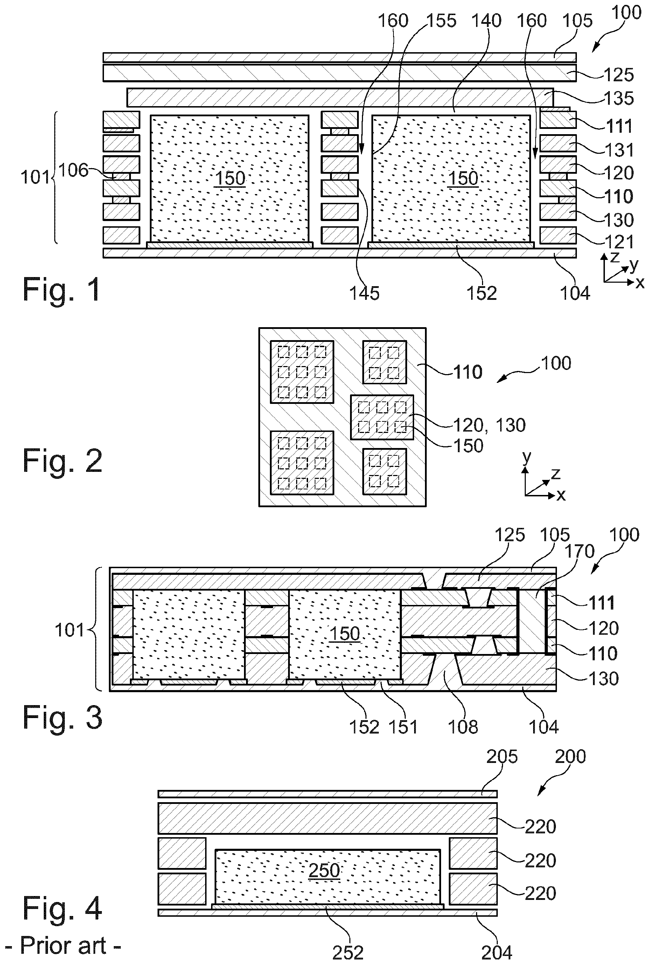

**Figure 4** shows a conventional circuit board 200 with an embedded component 250. A copper foil 204 is used as a basis and the component 250 is glued onto an adhesive layer 252 on the copper foil 204. Then, two layers of prepreg 220 are used as sidewalls, and a cover prepreg 220 as well as a further copper foil 205 are placed on top of the component 250.

However, this conventional approach may be limited by the build-up thickness (stack thickness), in particular to around 350 µm. This may be due to reduced mechanical stability of a higher build-up, especially during relamination and to a limitation of the possible prepreg resin flow. A higher build-up, e.g. due to larger components, may further lead to unfilled space between the component and the surrounding material.

### Summary of the Invention

There may be a need to embed a component in a multi-layer stack in an efficient and stable manner.

A component carrier and a manufacturing method are described.

According to an aspect of the invention, there is described a component carrier (e.g. a printed circuit board) having a (multi-layer) stack that comprises:
i) a core layer (in particular fully cured (reinforced) resin, e.g. FR4);
ii) a first electrically insulating layer structure (e.g. a non-(fiber-)reinforced resin layer) arranged on a first main surface of the core layer;
iii) a second electrically insulating layer structure (e.g. a (fiber-)reinforced resin layer) arranged on a second main surface of the core layer, wherein the second main surface is opposed to the first main surface (in particular wherein the core layer is sandwiched between two electrically insulating layer structures);
iv) a cavity in the (stack and/or) core layer, wherein the (cured) core layer defines a cavity lateral wall;
v) a component (e.g. an IC) with a component lateral wall, at least partially inserted in said cavity (in particular wherein the cavity lateral wall and the component lateral wall are essentially parallel).
The first electrically insulating layer structure and the second electrically insulating layer structure extend (at least) partially into the cavity, so that in a region between the cavity lateral wall and the component lateral wall, a first distinct resin flowed portion of the first electrically insulating layer structure and a second distinct resin flowed portion of the second electrically insulating layer structure are provided (in particular wherein the first distinct resin flowed portion is different from the second distinct resin flowed portion; in particular in the final component carrier product the resin flowed portions may be distinguished based on what is flowed before, e.g. through the recognition of filler directions).

According to a further aspect of the invention, there is described a method of manufacturing a component carrier, the method comprising:
i) providing a core layer;
ii) providing a first electrically insulating layer structure on a first main surface of the core layer;
iii) providing a second electrically insulating layer structure on a second main surface of the core layer, wherein the second main surface is opposed to the first main surface;
iv) forming a cavity in the core layer, wherein the core layer defines a cavity lateral wall;
v) inserting a component with a component lateral wall at least partially in said cavity;
vi) flowing the first electrically insulating layer structure, thereby forming a first distinct resin flowed portion, wherein said first distinct resin flowed portion is partially flowing into a region between the cavity lateral wall and the component lateral wall; and
vii) flowing the second electrically insulating layer structure, thereby forming a second distinct resin flowed portion, wherein said second distinct resin flowed portion is partially flowing into the region.

In the present context, the term "resin flowed portion" may refer to a part/portion of an electrically insulting layer structure (a resin layer with or without fillers) that is suitable to extend/flow towards/into a cavity for embedding a component. In an example, a resin flowed portion may comprise a resin matrix, preferably with a filler material. The filler material may comprise fibers (e.g. glass fibers) and/or filler particles (e.g. spheres, in particular glass spheres). Especially during a lamination process (application of heat and/or pressure), a not (fully) cured electrically insulting layer structure may (at least partially) flow, wherein the flowing part may be the resin flowed portion. Said portion may be influenced by a plurality of resin flow parameters, for example, resin material, filler properties, layer thickness, viscosity, curing state, etc. Based on the resin flow parameter and/or the position of the respective electrically insulting layer structure in the stack, a plurality of different flow behaviors may be enabled, in particular controlled.

Preferably, at least part of the resin flowed portion may (exclusively) extend/flow towards/in perpendicular to a stacking direction. In an example, the resin flowed portion originated from an electrically insulating layer structure may be free of a vertical offset. In other words, the electrically insulating layer structure may stretch laterally perpendicular to a stacking direction, thereby forming the resin flowed portion.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In an embodiment, the component carrier "stack" comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high density product. The stacking direction (height/thickness) may be arranged in the vertical direction z. Further, the stacking direction may be perpendicular to the two directions of main extension (along x and y) of the (plate-shaped) component carrier.

In an example, all layers of the component carrier may form the stack. Yet, in a preferred example, those layers may be defined as the stack, which are associated with the cavity. For example, the stack may be defined by layers being on the same vertical level as the cavity (surrounding the cavity). A top/bottom layer (directly) on/below the cavity may also be considered as a part of the stack.

In this context, the term "layer structure" may in particular refer to a continuous or discontinuous layer (or separated islands within the same plane) of electrically conductive or electrically insulating material. A plurality of such layers, parallel stacked one upon the other, may form the stack in the vertical direction.

In this context, the term "core layer" may in particular refer to a layer that carries the first and the second electrically insulating layer structures during the curing of said structures, in particular because the core layer is composed of a material that remains hard/rigid during the curing stage, for example because it is done of a (organic) material already in the cured material or it is done of a (inorganic) material, in particular an inorganic layer structure, having the hardness not affected during the curing stage. Said core is unequivocally distinguishable in the stack due to the fact that being not softened during the change from the rigid to the gelling or liquid form of the first and/or the second electrically insulating layer structure, the boundary profile of this core is recognizable. In an example, the core layer may comprise a plurality of electrically insulating layer structures and optionally a plurality of electrically conductive layer structures, for example a multilayer core.

According to an exemplary embodiment, the invention may be based on the idea that a component can be embedded in a component carrier multi-layer stack in an efficient and stable manner, when at least two distinct resin flows of at least two electrically insulating layer structures into a cavity (into which the component is placed) are controlled, in particular regarding their resin flow properties.

Conventionally (see Figure 4), only small build-ups (e.g. limited to 350 µm thickness) are possible, normally based on using similar embedding materials.

However, it has been found by the inventors that efficient and stable embedding, in particular enabling (significantly) higher build-up around an embedded component, may be enabled by varying different materials in the build-up (before pressing) and different parameters of the equipment(s) involved in the curing stage in a controlled manner, in particular predicting the formation and the extensions of the resin flowed portions associated to the respective electrically insulating layer structures during the curing of said electrically insulating layer structures, so that the resin flowed portions of said layers can be adapted to the respective requirements. For example, by using materials with different degrees of curing (e.g. B-stage, C-stage), the mechanical stability (during pressing) can also be improved, which may mean that a thicker structure (build-up) is possible.

Thus, resin layers with different flow properties may be combined in the stack build-up, thereby enabling higher mechanical stability and better filling possibilities of a larger volume. The resulting resin flow portions (in particular comprising respective fillers) may overlap and/or intermingle in the cavity and thereby form an especially robust, yet efficiently manufacturable, encapsulation of a component in the stack. Accordingly, build-up with increased thickness, e.g. larger than 350 µm, may be enabled. The described approach may be implemented into existing component carrier manufacture in a straightforward manner.

### Exemplary Embodiments

According to an embodiment, the first distinct resin flowed portion and the second distinct resin flowed portion at least partially overlap within the region, in particular along the component carrier planar direction (horizontal plane x,y) and/or the component carrier/stack thickness direction (vertical direction z). In an example, the at least two distinct flowed resin portions are intermingled together. Preferably, the resin portions do not flow in the horizontal direction only, but also (at least partially) in the vertical direction. In this manner, at least one of an overlap, a merging, an intermingling of distinct resin flowed portions may be observed in the region. This may provide the advantage that the stability of overlapped resin flowed portions may be increased in comparison to spatially separate resin portions, filling at the same time all the spaces between the cavity and the (embedded) component.

The overlap may be located within a volume defined by the area along the vertical extension lateral wall of the cavity and/or along a direction misaligned with respect to the component carrier-stack planar direction and/or along a not regular plane/shape.

A resin flowed portion may be a portion of the resin non-homogeneously merging from the regular planar extension of the respective electrically insulating layer structure towards and against at least an abutting surface not (planarly and/or frontally) aligned with at least one of the main surfaces of the at least two electrically insulating layer structures.

According to an embodiment, the first distinct resin flowed portion and the second distinct resin flowed portion mix in a specific form. For example, one distinct resin flowed portion may flow along a straight direction, while the other distinct resin flowed portion may build/form a helical structure around the straight distinct resin flowed portion.

According to a specific embodiment, the first distinct resin flowed portion and the second distinct resin flowed portion form/create a double helical form (with respect to each other).

According to a further embodiment, the first distinct resin flowed portion and the second distinct resin flowed portion (one or both) have wave-like forms/shapes. According to a further embodiment, the first distinct resin flowed portion and/or the second distinct resin flowed portion may swirl (with respect to each other).

According to an embodiment, the first distinct resin flowed portion and the second distinct resin flowed portion (in particular all resin flowed portions) are next (adjacent) to each other, preferably in direct contact.

According to a further embodiment, the first and/or second resin flowed portion may split into a plurality of resin flowed portions, for example forming a Y-like shape or a Ψ (greek letter psi) like shape.

The above identified embodiments may be a be a fingerprint feature of the described method respectively and thus may provide reliable adhesion and/or cohesion between the first distinct resin flowed portion and the second distinct resin flowed portion.

According to an embodiment, at least one of the first distinct resin flowed portion and the second distinct resin flowed portion comprises fillers, in particular wherein said fillers follow (at least partially) the flowing extension of the respective resin flowed portion. By the distribution of the fillers, the flow direction/extension of the respective flowed resin portions may be clearly observable. In this manner, a monitoring of the (distinct) resin flow directions may be enabled, e.g. in order to quality-check and/or further optimize/adjust the resin flow parameters. Furthermore, the fillers may enhance the stability of the layer stack, in particular by flowing into the region and thereby stabilizing the cavity and the embedded component.

In an embodiment, the fillers are provided in the (whole) first and/or second electrically insulating layer structure. This may enable a stabilisation along the (whole) horizontal stack direction.

In an embodiment, the profile of the core layer (and/or the further core layer) is distinguishable from the material of one or both of the at least two electrically insulating layer structures by the lower amount, in particular by the lack, of fillers in proximity of said profile. In particular, due to the hardened state of the core during the flowing of the resin of the first and/or the second electrically insulating layer structure, the fillers may not arrive to contact the core boundary surface, for surface tension reasons.

In an embodiment, the core layer is thicker than at least one of the first electrically insulating layer structure and the second electrically insulating layer structure.

In an embodiment, at least one flowed resin portion, in particular the direction of said portion, is distinguishable by at least one of the distribution, the amount, the lack of the filler. Depending on the resin flow properties, different information can be taken from the filler distributions. Moreover, this may indicate that a framework having preferably good adhesion and/or (physical or chemical) interaction between the first resin flowed portion and the second resin flowed portion is existing in at least a portion of the region.

According to an embodiment, the fillers comprise fibers (e.g. glass fibers) and/or particles, in particular spheres (e.g. glass spheres). The fillers may stabilize the respective layer and/or the stack. Further, the fillers may provide valuable information with respect to distinct flowed resin portions.

In an example, the term "filler" may refer to a material embedded in a resin matrix, wherein the filler material is different from the matrix material. In particular, the filler material is harder than the resin material, thereby providing a reinforcing effect. In case that the resin material is in an uncured (not fully cured) state, the filler material may move (be transported) within the matrix material and/or flow together with the matrix material.

In an example, fibers may be preferably applied to provide a certain stiffness to a layer structure, e.g. a prepreg. In a preferred example, the fibers are arranged in form of a network, wherein two fiber directions of main extension are perpendicular to each other. In a further example, the fibers are not intermingled on to each other and may be randomly distributed inside the resin.

In another example, filler particles, such as spheres, may be used to provide a certain flexibility (in addition to stability) to a layer structure, e.g. Ajinomoto build-up film (ABF).

In an embodiment the filler of the first resin flowed portion and the filler of the second resin flowed portion differs in at least one of: the composition, the size, the shape, the porosity. This may bring the advantage of having good physical and/ or chemical interacting in at least one region comprising the first resin flowed portion and the second resin flowed portion, since the two different resin flowed portions may interact synergistically, for example by physical attraction, even if the structures of the two flowed portion are different one to each other.

According to an embodiment, at an edge region, where the resin flowed portion(s) is/are provided, the amount of fillers in the respective resin flowed portion adjacent to said edge region is lower than the average amount of fillers of the respective resin flowed portion, in particular of the respective electrically insulating layer structure. In this manner, the stability and design flexibility may be increased. Moreover, this may ensure reliable encapsulation with the resin flowed portion in the edge region, since higher amount and/or concentration of resin matrix may be responsible for good interaction between respective resins in microscopic and/or atomic scale. Furthermore, flow comprising plurality of streamlines transporting fillers originated from complex flow mechanics may be a footprint of the method for manufacturing the corresponding component carrier, also allowing the recognition of the flow direction, the flow speed, and the flowability features of the resin flowed in proximity of said edge region.

In the present context, the term "edge region" may refer to a region defined by a structure already hardened or solid before the flowing of the resin flowed portion (e.g. previously cured core or a glass cloth). Said structure may define an edge around which a flowed resin portion at least partially flowed around ("flowing around the corner"). The edge region may be a specific part of the above defined region.

In an example, the edge region may be defined by a core layer, and the resin of an electrically insulating layer structure above or below the core layer flows at least partially around the (cured) core layer. During the resin flow/extension, the number of transported fillers may become lower, in particular when the flow is moved around the edge. In another example, the edge region may be defined by the component or one of the electrically insulating layer structures, in particular by the respective fillers. In a further example, the edge region may be defined by one of the electrically conductive layer structures, in particular in direct contact with a core layer.

In an example, at least a portion of a downstream amount/volume of flowed resin portion is free of fillers, preferably a portion that abuts against a surface that defines the edge region. The flow direction may be a direction defined from the planar portion of the respective electrically insulating layer structure towards a merged flowed portion at a free extremity.

In an example, each kind of edge, for example one defined by the component or the glass cloth of the core, may cause a decrease/lack of fillers, in particular due to the (sudden) direction disruption of the flowed resin portion from its previous extension.

According to an embodiment, the edge region is associated with one of the vertical extremities of the cavity lateral wall and/or the component lateral wall and/or one of the electrically insulating layer structures and/or one reinforcing structure (e.g. glass cloth in prepreg) in the respective electrically insulating layer structure and/or one of the electrically conductive layer structures of the stack. Thereby, different edges and/or corners may be at least partially surrounded (and thus protected) by flowed resin portions in an efficient and stable manner and thereby ensuring void free filling of material between the cavity and the component. In an example, association of the edge region can mean that a respective flowed resin portion is exclusively in direct contact with a sidewall of the above listed features. In another example, association of the edge region can mean that a respective flowed resin portion is in direct contact with a main surface (perpendicular to stack thickness direction) and sidewall of the above listed features.

According to an embodiment, an amount of fillers (per volume unit) at the cavity lateral wall is lower than an amount of fillers (per volume unit) at the component lateral wall. In particular, the amount of fillers per volume unit at the component side and/or at the cavity side is calculated along the entire height of the component/cavity. In this example, the fillers may be well transported within the flowed resin portion, so that an amount of fillers in the region is higher at the component than at the cavity lateral wall. For example, during a lamination process with high temperature and/or pressure, the resin layers may be pressed together, so that the fillers may be pressed towards the flowing/extension direction, i.e. towards the embedded component. Thereby, the component may be protected especially robust, since the method may enable to place a higher amount of fillers in a close lateral proximity to the surface of the component. Said higher amount of fillers may act as a physical and/or mechanical barrier or protection. On that purpose fillers with specific properties may be provided in the resin that is expected to flow toward the component (for example resin with conductivity and/or magnetic properties) to appropriately accumulate this filled around the component boundary surface(s).

According to an embodiment, the stack comprises more than three layers, in particular more than five, in particular more than seven layers, in particular more than ten layers, stacked on each other. This may provide the advantage that even build-ups with a high number of layers may be realized in a stable manner. Thereby, also a larger component may be efficiently embedded.

According to an embodiment, the cavity, in particular the cavity lateral wall, extends in stack thickness direction through at least one of the first electrically insulating layer structure, the second electrically insulating layer structure, further first electrically insulating layer structure, the further second electrically insulating layer structure, the further core layer. This may bring the advantage positioning a component having a bigger vertical extension (in stack thickness direction) than the thickness of the core layer in the cavity. Thus, a large variety of components may be embedded, for example an active component, i.e. having a p-n-junction implemented, an inactive component, i.e. a resistor, an inlay, an IC substrate, an interposer, a heat guiding structure, or a bridge structure.

According to an embodiment, at least two electrically insulating layer structures are stacked and arranged at the side of one of the main surfaces of the core layer. In other words, at least two electrically insulating layer structures are arranged above and/or below said core layer. Preferably, a first electrically insulating layer structure and a second electrically insulating layer structure with different resin flow properties are stacked above/below said core layer. The core layer may hereby function as a stabilisation layer, while the resin layers provide the flowed resin portions into the region (between the cavity lateral wall and the component lateral wall). In case that two or more core layers are applied, these may be sandwiched between a plurality of first/second electrically insulating layer structures.

In an example, one of the at least two electrically insulating layer structures may comprise reinforcing fibres, for example glass fibres, whereas another one of the at least two electrically insulating layer structure may be free from reinforcing fibres. Additionally or alternatively, all of the at least two electrically insulating layer structure may comprise reinforcing fibres or may be free from reinforcing fibres. The provision of different flowed resin leads to advantages such as filling of spaced with different volume extension one to each other and/or different distances from the electrically insulating layer structure, where the respective resin is flowed, and/or it may have the advantage of different (vertical) structures around the component.

According to an embodiment, at least one electrically insulating layer structure differs from at least one other electrically insulating layer structure in at least one resin flow property. This may provide the advantage that a desired flow behaviour (in particular regarding efficient and stable embedding) can be adjusted (e.g. by planning in advance) based on controlling the resin flow properties of at least two resin layers in a different manner.

According to an embodiment, the resin flow property comprises at least one of: flowability, curing state, viscosity, (layer) thickness, resin material, presence of filler, type of filler, material of filler, amount of fillers.

The flowability may depend on a plurality of conditions, for example the kind or resin material, the presence of a filler, the type of filler, the amount of said filler, etc.

By using materials with increased resin flow (e.g. prepreg with high flow properties, resin sheet), the larger space between the inlay/component and the cavity wall resulting from a higher structure may be completely filled. These materials can be used like regular electrically insulating layer structures, for example prepregs.

In the present context, the term "curing state" may in particular refer to a hardening (by polymerization and/or cross-linking) of the resin material. The term "fully cured" may hence refer to a state that cannot be further cured. For example, a first resin layer may be cured (hardened) to a higher extent than a second resin layer. Accordingly, the second resin layer may have a higher flowability (and lower viscosity) in comparison to the first resin layer. For example, a resin material may be uncured and in a so-called B-stage . In an example, the core layer is already in a fully cured state (C-stage).

In an example, in a cured state, the resin material is more cured (hardened) than in an uncured state. In other words, a cure state such as the state of cross-linking and/or the viscosity changes from the uncured state to the cured state (over time, preferably by applying temperature and/or pressure). According to a general definition, there are (at least) the following states:
A-stage: no curing (chemical reaction) has not yet started.
B-stage: the curing has started, and the viscosity has begun to increase.
C-stage: the resin is completely cured.

For example, in a pre-cured state, the resin material may be partially able to flow. In contrast to this, a so-called core layer normally comprises fully cured material in order to serve for mechanical stabilization. In particular, the core layer may comprise (fully cured) polymeric organic material and/or glass and/or ceramic material. There are different methods that allow to determine the cure state. In an example, the cure state is predetermined to allow a specific flow amount and/or a specific flow speed. An applied dielectric material may thus be tuned (for example by waiting for a specific time, using temperature curing (elevated temperatures), or hardening with UV light) in order to achieve the desired cure state based on a cure state criterion. In an example, curing may be done by a (any) electromagnetic radiation, e.g. with a wavelength 0.1 to 3000 nm, in particular 10 to 2000 nm, more in particular 100 to 1000 nm. Curing may be also done using a heat source, whereby a source of electromagnetic radiation may also be seen as a heat source.

Based on at least one resin flow parameter, or preferably a combination thereof, desired resin flow behaviour may be triggered.

According to an embodiment, the material composition of at least two electrically insulating layer structures are different. The term "material composition" may e.g. refer to a resin material, a filler material/property etc. This may provide the advantage that distinct flowed resin portion may be provided, in particular based on predetermined material parameters.

According to an embodiment, the stack comprises a further core layer, wherein at least one, in particular at least two, more in particular two different, electrically insulating layer structures are sandwiched between the core layer and the further core layer. A higher number of core layers (multi-core PCB) may enhance the stability, while also the flexibility may be increased. Instead of one (thick) core layer, two or more (in particular thinner) core layers may be applied, which can be inserted between (not fully cured) resin layer in order to have a high design flexibility, preferably enabling a high build-up around the component. Further, the resin flow behaviour may be controlled by providing core layers (that essentially do not flow) in between, wherein said core layers may e.g. serve as edge portions.

The stack structure can be supplemented with additional cured materials (e.g. possible with copper structuring on both sides to increase the density). They increase the mechanical stability of the structure e.g. during a relamination process, which means that higher structures may be possible.

According to an embodiment, the component carrier further comprises: an electrically conductive (layer) structure (e.g. a copper foil, a metal/copper layer, a metal/copper pad, a metal/copper trace, etc.) arranged between two electrically insulating layer structures and/or between one electrically insulating layer structure and the core layer. Such an additional electrically conductive structure may enable an efficient and (design) flexible electrical connection within the stack. Said electrically conductive structures may be for example electrically interconnected by (blind) vias within the stack.

According to an embodiment, the amount and/or the extension of resin material of a flowed resin portion of the respective electrically insulating layer structure is associated with the location of said electrically insulating layer structure in the stack, in particular being higher towards the external stack surface. Said external surface may be suitable to be directly contacted by one lamination surface of a laminating apparatus. This may provide the advantage that the flowed resin portion(s) may (fully) embed the component in the cavity by their extension/flow. For example, the sidewalls and/or the top surface of the component may be covered by one or more flowed resin portions, in particular during a lamination process, when the flow is enhanced by heat/pressure.

According to an embodiment, the volume of resin between the (cavity lateral wall and/or the) core layer and the component (lateral wall), in particular adjacent to the component surface, is mainly flowed resin portion of the respective electrically insulating layer structure close (e.g. the next or the next but one layer with respect to the external stack surface) or at the external stack surface. In an example, the external stack surface may refer to an external surface of the multi-layer stack that is arranged besides (surrounding) the cavity (same vertical level and/or an additional cover layer on top/bottom of the component). Hereby the component carrier external surface may not correspond to the external stack surface. In another example, the external stack surface may relate to an external surface of the component carrier.

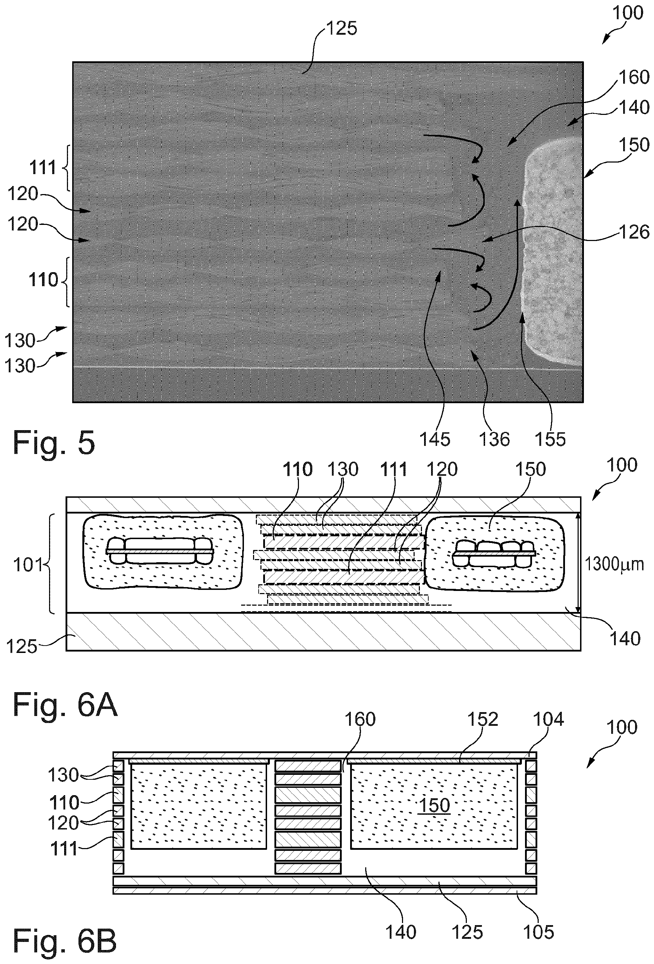

For example in Figure 5, it is shown by an arrow that the second layer from below (being a resin layer with filler particles but without fibers) (i.e. close to the lower external stack surface) comprises a flowed resin portion that extends through the cavity (region) and along the lateral wall of the embedded component up to the upper external stack surface.

According to an embodiment, the flow direction of at least one resin flowed portion is directed towards at least one of the external stack surfaces, in particular wherein at least one resin flowed portion is exposed at said external stack surface, more in particular wherein at least one resin flowed portion extends beyond said external stack surface. Thereby, an especially efficient and stable embedding/encapsulation may be enabled. For example, by choosing a high flowability/low viscosity for a specific resin layer, the resin flowed portion of said resin layer may extend/flow (significantly) more than other resin flowed portions.

According to an embodiment, at least one resin flowed portion extends over a portion, in particular a main surface, of the component. Also this feature may provide the advantage that an especially efficient and robust embedding of the component may be enabled. The resin flowed portion may (completely) cover/surround the component, thereby eventually making an additional cover structure obsolete.

According to an embodiment, the component comprises at least one electric connection (e.g. a pad, a terminal, etc.), and wherein said electric connection is at least partially encircled by at least one resin flowed portion, in particular by the at least one resin flowed portion with a high-flow material and/or the at least one resin flowed portion close(st) to or at the external stack surface. This may provide the advantage that the electric contact of the embedded component is well protected in resin flowed material that adjusts itself to the shape of the electric contact during the flow.

According to an embodiment, at least two components are embedded, which are different from each other, e.g. in at least one of type, shape, size (e.g. different height).

According to an embodiment, the term "component" may also refer to a heat guiding structure and/or an inlay and/or and IC substrate and/or an interposer.

According to an embodiment, the component carrier further comprising: a vertical electrical through-connection (e.g. a through via or a blind via; a straight or a tapering via) that extends through at least one of the first electrically insulating layer structure, the core layer, the second electrically insulating layer structure (or a combination thereof), in particular through the whole stack (whole component carrier or multi-layer stack around the cavity).

Thereby, efficient and reliable electrical interconnections in the stack may be realized. The vertical electrically conductive through-connection may be electrically connected with at least on electrically conductive structure in the stack. The vertical electrically conductive through-connection may electrically interconnect external surfaces of the stack and/or the component carrier. In the manufacture process, the vertical electrically conductive through-connection may be formed after the embedding process and/or after a lamination step.

According to an embodiment, the component carrier and/or the stack further comprising: an upper/lower electrically insulating layer structure, in particular (fiber) reinforced or non-(fiber-) reinforced, arranged on top/bottom of the stack and/or the component. Such an additional upper/lower electrically insulating layer structure may be provided to further stabilize the component carrier, or as a basis for further build-up. In comparison to the first/second electrically insulating layer structure, the upper/lower electrically insulating layer structure may be located in the vertical and not the horizontal direction (in other words: in the stacking direction and not perpendicular to the stacking direction) with respect to the cavity/component (not on the same vertical level as the com ponent/cavity) .

According to an embodiment of the method, flowing comprises: controlling the flow of the first distinct resin flowed portion and/or the second distinct resin flowed portion by adjusting at least one resin flow parameter, in particular wherein the resin flow parameter comprises at least one of a cure state, a viscosity, a flowability, a resin material, a layer thickness, a filler material, a filler type, an amount of fillers. As described above, a specific selection of the resin layers and their respective resin flow properties may enable a controlled flow of resin portions in the region between cavity lateral wall and component.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 shows a cross-section of a component carrier, according to an exemplary embodiment of the invention.
Figure 2 shows a top view on a component carrier, according to an exemplary embodiment of the invention.
Figure 3 shows a cross-section of a component carrier with a vertical through connection, according to an exemplary embodiment of the invention.
Figure 4 shows a conventional circuit board.
Figure 5 shows a microscopic image of cross-section of a component carrier with distinct resin flowed portions, according to an exemplary embodiment of the invention.
Figures 6A and 6B show a cross-section of a component carrier, according to other exemplary embodiments of the invention.
Figures 7 to 9 respectively show microscopic images of component carrier resin, according to exemplary embodiments of the invention.

### Detailed Description of the Drawings

**Figure 1** shows a cross-section (for better understanding in an exploded view) of a component carrier 100, according to an exemplary embodiment of the invention. The component carrier 100 comprises a stack 101 with a core layer (structure) 110 and a further core layer 111 (i.e. a multi-core). The core layer 110 is sandwiched between a first electrically insulating layer structure 120, arranged on a first main surface of the core layer 110, and a second electrically insulating layer structure 130, arranged on a second main surface of the core layer 110, wherein the second main surface is opposed to the first main surface.

In this example, the first electrically insulating layer structure 120 is a non-fiber reinforced resin layer (e.g. a resin sheet), while the second electrically insulating layer structure 130 is a fiber-reinforced resin layer, e.g. a prepreg layer. The stack 101 also comprises a further first electrically insulating layer structure 121 and a further second electrically insulating layer structure 131.

In an example, one of the at least two electrically insulating layer structures 120, 130 may comprise reinforcing fibers, for example glass fibers, whereas another one of the at least two electrically insulating layer structures 120, 130 may be free from reinforcing fibers. Additionally or alternatively, all of the at least two electrically insulating layer structure 120, 130 may comprise reinforcing fibers or may be free from reinforcing fibers.

Two cavities 140 are formed in the above described stack 101, wherein each cavity 140 is defined by a cavity lateral (side) wall 145. The core layer 110 (and the further core layer 111) is an already cured layer and can thereby define said cavity lateral wall 145. Preferably, the cavity lateral wall 145 may extend in stack thickness direction (z). Additionally or alternatively the extension direction of the cavity lateral wall 145 may be inclined to the stack thickness direction. Optionally, the core layer 110 may at least partially comprise an inorganic layer structure, for example glass or ceramic material. The cavity 140 is further formed within the two first electrically insulating layer structures 120, 121 and the two second electrically insulating layer structures 130, 131. In this example, the two cavities 140 have similar lateral extension (in stack thickness direction and in planar direction). Alternatively, at least one of the lateral extensions of one cavity 140 may be different than the same lateral extension of the other (second) cavity 140.

In each cavity 140, a respective component 150 is (inserted and) placed on top of an adhesive (glue) layer 152. Alternatively, a plurality of components 150 (having similar or different extension and/or shape) may be located in one cavity 140. Each component 150 (in this example similar components but they can also be different in size/shape/type), e.g. an inlay and/or a semiconductor element and/or a heat guiding element and/or an IC substrate and/or an interposer, has component lateral (side) walls 155.

Preferably, an extension direction of a component lateral (side) wall 155 may be parallel to an extension direction of a cavity lateral side wall 145. Alternatively, an extension direction of a component lateral (side) wall 155 may be inclined to an extension direction of a cavity lateral side wall 145. Regions 160 are defined between respective cavity lateral walls 145 and component lateral walls 155, wherein resin material of the uncured electrically insulating layer structures 120, 121, 130, 131 flows/extends into said regions 160 (of the cavities 140). For example, a first distinct resin flowed portion 126 of the first electrically insulating layer structure 120 and a second distinct resin flowed portion 136 of the second electrically insulating layer structure 130 extend into the regions 160 (not shown in Figure 1).

It can be further seen in the exploded view of Figure 1 that at least one, in particular at least two, electrically conductive structures 106 are arranged between two electrically insulating layer structures 120, 130 and between one electrically insulating layer structure 120, 130 and a core layer 110, 111. Optionally, at least one, in particular at least two, electrically conductive structures 106 may be arranged between one of the two second electrically insulating layer structures 130, 131 and one of the group of: the first electrically insulating layer structure 120, the core layer 110, or the second electrically insulating layer structure 130. Thereby, a more flexible electrical connection within the stack 101 can be enabled.

In this example, the stack 101 is defined by the layers 106, 110, 111, 120, 121, 130, 131 that are arranged on the same vertical level as the cavity. The stack 101 can also include a resin layer on top of the component 150, wherein said resin layer (essentially) originates from resin flowed portions 126, 136. On top of the stack 101, there is arranged an upper fiber-reinforced electrically insulating layer structure 135 and an upper non-(fiber-) reinforced electrically insulating layer structure 125.

Preferably, the upper fiber-reinforced electrically insulating layer structure 135 may be arranged between the stack 101 and the upper non-(fiber-) reinforced electrically insulating layer structure 125. Alternatively, the upper non-(fiber-) reinforced electrically insulating layer structure 125 may be arranged between the stack 101 and the upper fiber-reinforced electrically insulating layer structure 135. Further, a first electrically conductive layer structure 104 (e.g. a copper foil) is arranged below the stack 101, while a second electrically conductive layer structure 105 is arranged in top of the upper non-(fiber-) reinforced electrically insulating layer structure 125.

In this example, the resin flowed portions 126, 136 of the first electrically insulating layer structure 120 and the second electrically conductive layer structure 130 are distinct since said electrically insulating layer structures 120, 130 differ from each other in resin flow properties. These properties include e.g. flowability, curing state, viscosity, layer thickness, resin material, type of filler, material of filler, amount of fillers, etc.

In a specific example, the stack 101 may be formed as follows (from bottom to top):
prepreg (fiber- reinforced electrically insulating layer in B stage),
resin sheet (non-(fiber-) reinforced electrically insulating layer in B stage),
cured prepreg (fiber- reinforced electrically insulating layer in C stage),
prepreg, resin sheet, cured prepreg, resin sheet, prepreg.

The layer 135 may be optionally applied on top of the stack 101 (slightly larger in area as the cavity, like a lid) in order to help filling the cavity.

**Figure 2** shows a top view on a component carrier 100 (e.g. according to Figure 1), according to an exemplary embodiment of the invention. In this top view, the core layer 110 can be seen that extends essentially over the whole area of the component carrier 110. The components 150 are embedded in this example only in specific areas in form of arrays. Only in these areas, the electrically insulating layer structures 120, 130 are provided in order to partially flow into respective cavities 140 around the components 150. Preferably, an array may comprise a regular matrix having n rows and m columns. Alternatively, the array may comprise randomly placed components. The specific areas may be placed randomly inside the component carrier. Alternatively, they also may build a n by m matrix.

**Figure 3** shows a cross-section of a component carrier 100 with a vertical through connection 170, according to an exemplary embodiment of the invention. This architecture is comparable to the one of Figure 1, yet not shown in an exploded view. Further, blind via 108 connections are provided that respectively extend through the core layers 110, 111 and the second electrically insulating layer structures 130. These blind vias 108 are further electrically connected to the electrically conductive structures 106 embedded in the stack 101 (see also Figure 1). Optionally, a surface finish, for example a solder resist and/or gold, may be located at an exposed surface of the component carrier 100.

The electrically conductive vertical through-connection 170 extends here through three layers of the stack 101: the core layer 110, the first electrically insulating layer structure 120, and the further core layer 111. In this example, the electrically conductive vertical through-connection 170 has been drilled through said three layers 110, 120, 111, and the sidewalls comprise electrically conductive material (e.g. plated through-hole). The rest of the electrically conductive vertical through-connection 170 can be either filled with electrically conductive material or electrically insulating material, e.g. a resin or plug material. Mechanical drilling or laser drilling may be used to manufacture an electrically conductive vertical through-connection 170 and/or a blind via 108. At least one component electric contact 151 may be located between an electrically conductive layer structure 104, 105, 106 and the component and may be configured to ensure reliable physical and/or electrical and/or thermal contact. The component electric contact 151 may be connected to a conductive layer structure 104, 105, 106. Optionally, electrical contacts on both opposed sides of the component may be provided (not shown).

**Figure 5** shows a microscopic image of cross-section through a component carrier 100 stack with distinct resin flowed portions 126, 136, according to an exemplary embodiment of the invention. This cross-section can be for example associated with a component carrier 100 described for Figure 1. It can be seen a component 150 in a cavity 140, wherein the at least a portion of the cavity lateral wall 145 is defined by the already cured core layers 110. The fiber enforced core layers 110 (fibers networks can be clearly seen in this image) are already cured during manufacture, so that the resin of said core layers 110 does (essentially) not flow/extend into the cavity 140. Preferably, the component 150, in particular the component lateral side wall 155, is free from contact with (glass) fibers of the fiber enforced core layer 110 and/or the fiber- reinforced electrically insulating layer 130.

First electrically insulating layer structures 120 (in this example that containing the fiber enforced resin layers, but with the resin not (fully) cured) and second electrically insulating layer structures 130 (in this example that containing the fiber enforced resin layers, but with the resin not (fully) cured) are stacked above and below with the core layers 110, 111, the first electrically insulating layer structures 120, and the second electrically insulating layer structures 130 comprising a through hole defining the cavity 140 through their stack. In the shown embodiments, several electrically insulating layer structures 120, 130 are provided at one side and/or the opposed side (of the main surfaces) of each core 110, 111, preferably each of those comprising fiber reinforcing layer/cloth therein.

According to an alternative not shown embodiment, at least one of said first electrically insulating layer structures 120 or second electrically insulating layer structures 130 can be free of fiber reinforcing layer/cloth. According to a further alternative not shown embodiment, only one electrically insulating layer structure 120 or 130 may be provided on one side of the core, whereas a plurality of electrically insulating layer structures 120, 130 may be provided on the opposed side of the same component.

Since the first electrically insulating layer structures 120 and the second electrically insulating layer structures 130 are not (fully) cured during manufacture, respective resin portions flow into the region 160 between cavity lateral wall 145 and component lateral wall 155 preferably completely filling the region 160 with (solid) material. Due to different resin flow properties of said uncured layers 120, 130, distinct resin flowed portions 126, 136 are visible in the component carrier 100 cross-section.

It can be clearly seen that fibers in second flowed resin portions 136 of the second electrically insulating layer structures 130 extend into the cavity 140 (region 160) with respect to the fibers of the cured core layers 110 that define the cavity lateral wall 145 and do not extend into the region 160. Alternatively, fibers of the fiber-reinforced electrically insulating layer 130 may be in similar, in particular the same, lateral position regarding one extension perpendicular to stack thickness direction (z) with respect to the fibers of the cured core layers 110 and optionally with respect to the fibers of further first fiber reinforced electrically insulating layer structure 121 and/or further second fiber reinforced electrically insulating layer structure 131.

In this example, the first electrically insulating layer structures 120 comprise filler particles (spheres), so that it can be clearly observed that the fillers in first flowed resin portions 126 extend into the region 160. Additionally, the second electrically insulating layer structure 130 comprise filler particles (spheres), so that it can be clearly observed that the fillers in the second flowed resin portion 136 extend into the region.

The arrows in Figure 5 indicate resin flow directions of respective layers 120, 130. It can be seen that the resin flowed portion 126, 136 are distinct from each other and each resin layer 120, 130 extends in a different manner into the region 160. In particular, the fibers and the filler particles of the respective layers 120, 130 make the different resin flows clearly visible. In particular, the filler particles may further extend/flow into the region 160 of the cavity. By adjusting the above described resin flow properties of the different resin layers 120, 130 (e.g. cure state, filler properties, flowability, viscosity), the flow behavior can be controlled and optimized to obtain an efficient and stable component 150 embedding in a multi-layer stack 101, even in case of large components 150 and/or high build-up designs.

For example, a first distinct resin flowed portion 126 and the second distinct resin flowed portion 136 at least partially overlap within the region 160 along the component carrier planar direction x,y and the component carrier thickness direction z. Preferably, the overlap interface may be free from fillers. Thereby only the resin material of the first electrically insulating layer structure 120 and second electrically insulating layer structure 130 may be in direct contact. Said interface may have a thickness smaller than 5 µm, in particular smaller than 1 µm. The overlap may comprise a portion having a regular, in particular straight, shape, for example two planes stacked one over the other one. Additionally or alternatively, the overlap may comprise a portion having an irregular shape, in particular a curve-, wave-, or swirl- like structure. Further additionally or alternatively, the overlap may comprise a portion, in which one distinct resin flowed portion 126, 136 comprises a bifurcation. Thereby, the resin flowed portion splits into at least two resin flowed portions having a shape like a "Y".

Depending on the resin flow properties, an amount of fillers per volume unit at the cavity lateral wall 145 is lower or higher than an amount of fillers per volume unit at the component lateral wall 155, i.e. the fillers are either efficiently moved by the resin flow or rather keep in place. For example, a higher amount of fillers may be transported to the component lateral wall 155 than remaining at the cavity lateral wall 145. In case of an edge region (e.g. a cured core layer 110 or a component side/top wall or the fiber enforced resin layers/cloths) the resin portion can flow around said edge (around the corner), so that less fillers may be transported. This may be related to complex flow mechanics during manufacture, which will create a fingerprint feature of the manufacturing process.

The amount/extension of resin material of a flowed resin portion 126, 136 of the respective electrically insulating layer structure 120, 130 is associated with the location of said electrically insulating layer structure 120, 130 in the stack 101 and can be higher towards the external stack surface. As indicated by the arrows, the flow direction can extend upwards through the (whole) region 160 and along the component lateral wall 155. In other words, the volume of resin between the core layer 110 and the component 150 is mainly resin flowed portion 126, 136 of the respective electrically insulating layer structure 120, 130 close or at the external stack surface. A resin flowed portion 126, 136 can be even exposed at said external stack surface or extend beyond said stack surface or the component upper surface.

**Figures 6A and 6B** show a cross-section of a component carrier 100, according to other exemplary embodiments of the invention. Figure 6A shows hereby a microscopic image (SEM), while Figure 6B shows a schematic design in exploded view.

Like in the example of Figure 5, the stack 101 comprises two core layers 110, 111, three first electrically insulating layer structures 120, and three second electrically insulating layer structures 130. Below the embedded components 150, a respective cavity 140 is left open, which is filled by flowed resin during the manufacture process.

Instead of a single core, a multi-layer printed circuit board is used in this example, into which the necessary cavities 140 have been cut beforehand. The maximum thickness of this multi-layer is thus limited by the cutting process, e.g. laser cutting.

In a specific example, the stack may be formed as follows (from bottom to top): copper foil, three prepreg layers (here 125 µm thickness each), core layer (200 µm), two prepreg layers (125 µm each), further core layer (200 µm), two prepreg layers (125 µm each), copper foil.

Figure 6A shows that the openings of the several layers forming the cavity are misaligned. This can be for example the case of openings previously formed on each one of the layers before their stacking. Even if misaligned lateral walls of each cavity occur (also resulting in several misaligned edges, for example due to the misaligned fibers), the proper choice of the uncured resin, the dimensions, and the number of electrically insulating layer structures compensates this misalignment assuring the controlled filling of the respective cavity.

Figure 6B: the cavity walls are linearly developed. This can be the case of the formation of the cavities after the layers have been stacked one to each other; in this case the choice of the uncured resin, the dimensions, and the number of electrically insulating layer would lead to a more uniform materials/dimension, eventually focused to the resin flowing toward the upper side, assuring the filling of the upper resulting space between the upper core 110 and the continuous insulating layer 125.

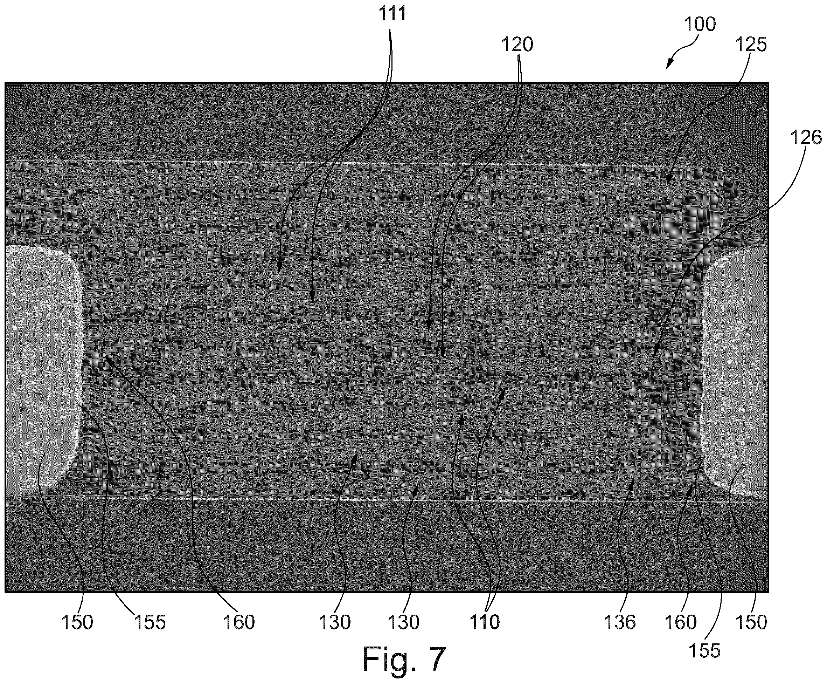

Figures 7 to 9 respectively show microscopic images of component carrier resin (flows), according to exemplary embodiments of the invention.

**Figure 7** shows a microscopic image comparable to the one of Figure 5, with the difference that two embedded components 150 can be seen. Thereby, resin flow directions 126, 136 to both sides of the multi-layer stack can be observed. It can be seen that on the left side (left region 160), the fibers extend towards the component lateral wall 155 and (essentially) contact said lateral wall 155, whereas on the right side, the fibers are distanced with respect to the respective component 150. In this shown embodiment, not only the layers are misaligned one to each other (as shown in Figure 6A) but also the components are misaligned with respect to the respective cavity. In view of these imprecisions and/or these tolerances a proper choice of the uncured resin, the dimensions, and the number of electrically insulating layer structures, may compensate these misalignments.

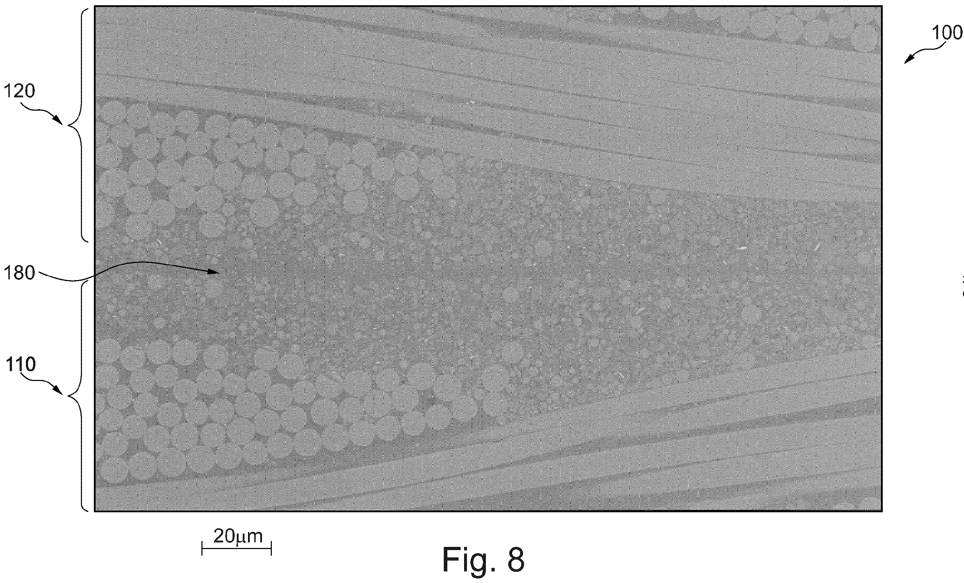

**Figure 8** shows a microscopic image with a detailed view of the interface between the first electrically insulating layer structure 120 and the core layer 110. Both the first electrically insulating layer structure 120 and the core layer 110 comprise the respective fiber reinforced cloth and comprise the resin having fillers therein. This microscopic image shows that after the curing of the first electrically insulating layer structure 120, this layer is distinguishable from the core layer 110 because between the two layers a portion having not fillers (or less fillers) occurs (filler-free interface 180). This is due to the fact that during the flowing of the resin of the first electrically insulating layer structure 120, due to the surface tension of the already cured core layer 110, the fillers do not go in contact with the core layer 110, resulting in this boundary fillers-free (or with less fillers than the amount in the rest of the flowed resin) profile, allowing the clear recognition of the core layer profile. For the same reasons, also the flowing of the resins around the core layer 110 and/or touching one to each other are clearly recognizable in the cross section of the component carrier 100 (see figures 5 and 7) due to specific interaction of the two resins defining the recognizable boundary profiles among them.

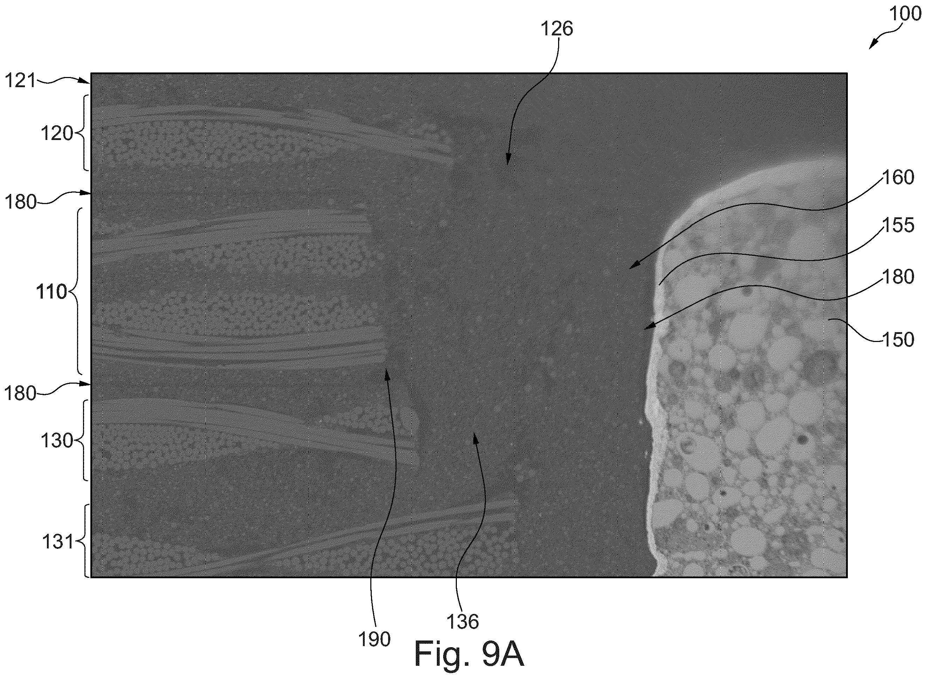

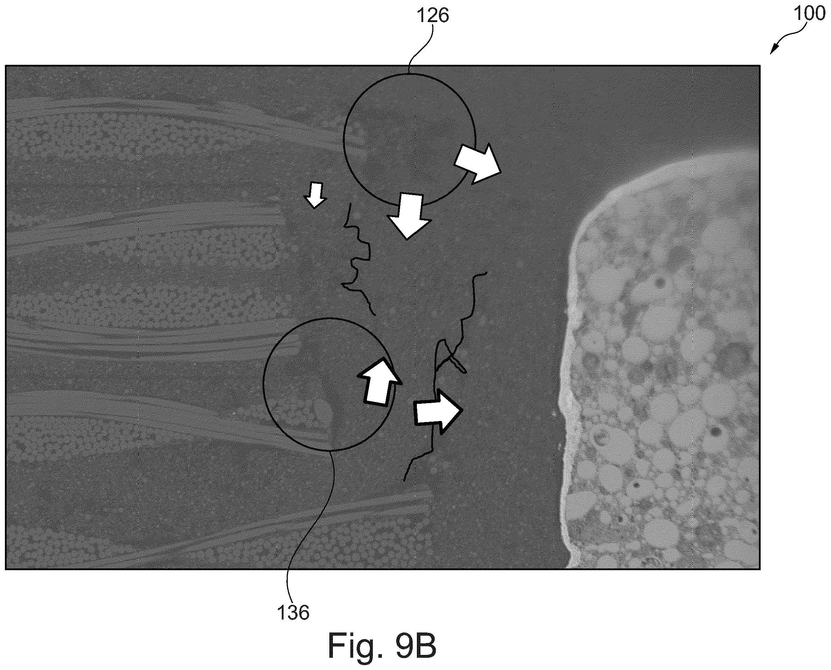

**Figure 9** shows a detailed microscopic image comparable to the one of Figure 5. While Figure 9A shows the SEM image without indications, in Figure 9B, the distinct resin flowed portions 126, 136 are indicated by arrows. The layers have already described for e.g. Figure 5 above.

First resin flowed portion 126: due to flow mechanics, this portion lacks filler particles, since during a pressing (lamination) step, the particles follow the flow. In this portion, there may be a slow flow and therefore particles may not be pushed into this space. Only resin material is filling up those areas since is it less dense and less energy may be required to fill those areas

Second resin flowed portion 136: here an edge region 190 (at the corner of the core layer 110) can be seen, where few particles are present.

In Figure 9B, irregular lines are indicated with particle-reduced interfaces where mixing of two flowed portions is occurring. Next to the component 150 sidewall 155, there is also a particle free interface.

### Reference signs

- 100: Component carrier
- 101: Stack
- 104: Electrically conductive layer structure
- 105: Further electrically conductive layer structure
- 106: Electrically conductive structure
- 108: (Blind) Via
- 110: Core layer
- 111: Further core layer
- 120: First electrically insulating layer structure; e.g. resin layer
- 121: Further first electrically insulating layer structure
- 125: Upper/lower non-fiber-reinforced electrically insulating layer structure
- 126: First distinct resin flowed portion
- 130: Second electrically insulating layer structure; e.g. fiber-reinforced resin layer
- 131: Further second electrically insulating layer structure
- 135: Upper/lower reinforced electrically insulating layer structure
- 136: Second distinct resin flowed portion
- 140: Cavity
- 145: Cavity lateral wall
- 150: Component
- 151: Component electric contact
- 152: Adhesive layer
- 155: Component lateral wall
- 160: Region between cavity lateral wall and component lateral wall
- 170: Electrically conductive vertical through-connection
- 180: Filler-free interface
- 190: Edge region

## Claims

1. A component carrier (100) having a stack (101) that comprises:
a core layer (110);
a first electrically insulating layer structure (120) arranged on a first main surface of the core layer (110);
a second electrically insulating layer structure (130) arranged on a second main surface of the core layer (110), wherein the second main surface is opposed to the first main surface;
a cavity (140) in the core layer (110), wherein the core layer (110) defines a cavity lateral wall (145);
a component (150) with a component lateral wall (155), at least partially inserted in said cavity (140);
wherein the first electrically insulating layer structure (120) and the second electrically insulating layer structure (130) extend at least partially into the cavity (140), so that
in a region (160) between the cavity lateral wall (145) and the component lateral wall (155), a first distinct resin flowed portion (126) of the first electrically insulating layer structure (120) and a second distinct resin flowed portion (136) of the second electrically insulating layer structure (130) are provided.

2. The component carrier (100) according to claim 1,
wherein the first distinct resin flowed portion (126) and the second distinct resin flowed portion (136) at least partially overlap within the region (160),
in particular along the component carrier planar direction (x,y) and/or the component carrier thickness direction (z).

3. The component carrier (100) according to claim 1 or 2,
wherein at least one of the first distinct resin flowed portion (126) and the second distinct resin flowed portion (136) comprises fillers,
in particular wherein said fillers follow the flowing extension of the respective resin flowed portion (126, 136).

4. The component carrier (100) according to claim 3,
wherein the fillers comprise fibers and/or particles, in particular spheres.

5. The component carrier (100) according to claim 3 or 4,
wherein at an edge region, where the resin flowed portion is provided, the amount of fillers in the respective resin flowed portion (126, 136) adjacent to said edge region is lower than the average amount of fillers of the respective resin flowed portion (126, 136),
in particular of the respective electrically insulating layer structure (120, 130).

6. The component carrier (100) according to claim 5,
wherein the edge region is associated with one of the vertical extremities of the cavity lateral wall (145) and/or the component lateral wall (155) and/or one of the electrically insulating layer structures (120, 130) and/or one reinforcing structure in the respective electrically insulating layer structure (120, 130).

7. The component carrier (100) according to one of claims 3 to 6,
wherein an amount of fillers per volume unit at the cavity lateral wall (145) is lower than an amount of fillers per volume unit at the component lateral wall (155).

8. The component carrier (100) according to one of the preceding claims,
wherein at least two electrically insulating layer structures (120, 130) are stacked and arranged at the side of one of the main surfaces of the core layer (110).

9. The component carrier (100) according to one of the preceding claims, wherein at least one electrically insulating layer structure (120, 130) differs from at least one other electrically insulating layer structure (120, 130) in at least one resin flow property.

10. The component carrier (100) according to claim 9,
wherein the resin flow property comprises at least one of: flowability, curing state, viscosity, thickness, resin material, type of filler, material of filler, amount of fillers.

11. The component carrier (100) according to one of the preceding claims, wherein the amount and/or the extension of resin material of a resin flowed portion (126, 136) of the respective electrically insulating layer structure (120, 136) is associated with the location of said electrically insulating layer structure (120, 130) in the stack (101),
in particular being higher towards the external stack surface.

12. The component carrier (100) according to one of the preceding claims, wherein the volume of resin between the core layer (110) and the component (150), in particular adjacent to the component surface, is mainly resin flowed portion (126, 136) of the respective electrically insulating layer structure (120, 130) close or at the external stack surface.

13. The component carrier (100) according to one of the preceding claims, wherein the flow direction of at least one resin flowed portion (126, 136) is directed towards at least one of the external stack surface,
in particular wherein at least one resin flowed portion (126, 136) is exposed at said external stack surface, more in particular wherein at least one resin flowed portion (126, 136) extends beyond said external stack surface.

14. The component carrier (100) according to one of the preceding claims, further comprising:
an upper and/or lower electrically insulating layer structure (125, 135), in particular reinforced (135) or non-reinforced (125), arranged on top of the stack (101) and/or the component (150).

15. A method of manufacturing a component carrier (100), the method comprising:
providing a core layer (110);
providing a first electrically insulating layer structure (120) on a first main surface of the core layer (110);
providing a second electrically insulating layer structure (130) on a second main surface of the core layer (110), wherein the second main surface is opposed to the first main surface;
forming a cavity (140) in the core layer (110), wherein the core layer (110) defines a cavity lateral wall (145);
inserting a component (150) with a component lateral wall (155), at least partially in said cavity (140);
flowing the first electrically insulating layer structure (120), thereby forming a first distinct resin flowed portion (126), wherein said first distinct resin flowed portion (126) is partially flowing into a region (160) between the cavity lateral wall (145) and the component lateral wall (155); and
flowing the second electrically insulating layer structure (130), thereby forming a second distinct resin flowed portion (136), wherein said second distinct resin flowed portion (136) is partially flowing into the region (160).
